# EUROPEAN PATENT APPLICATION

(11) **EP 4 095 929 A1**
(43) Date of publication of application: **30.11.2022**
(21) Application number: 20915209.9
(22) Date of filing: 22.10.2020
(51) Int. Cl.: H01L 31/0216, H01L 31/0352, H01L 31/18

(54) **INTERMEDIATE CONNECTION LAYER, LAMINATED PHOTOVOLTAIC DEVICE, AND PRODUCTION METHOD THEREOF**

(30) Priority: 21.01.2020 CN 202010072789
(71) Applicant: Longi Green Energy Technology Co., Ltd., Xi'an, Shaanxi 710100 (CN)
(72) Inventor: WU, Zhao, Shaanxi 710100 (CN); XU, Chen, Shaanxi 710100 (CN); LI, Zifeng, Shaanxi 710100 (CN)
(74) Representative: Viering, Jentschura & Partner mbB Patent- und Rechtsanwälte
(86) International application number: PCT/CN2020/122769
(87) International publication number: WO 2021/147403

(57) **Abstract**

The present disclosure provides an intermediate series-connecting layer, a laminated photovoltaic device and a fabricating method, which relates to the technical field of solar-energy photovoltaics. The intermediate series-connecting layer is light-transmittable; the intermediate series-connecting layer includes a longitudinal conducting layer; and the longitudinal conducting layer is formed by nano-sized conducting columns that longitudinally grow; or the longitudinal conducting layer includes nano-sized conducting units that are separately distributed, and insulating and separating bodies located between neighboring the nano-sized conducting units, and the insulating and separating bodies transversely insulate the nano-sized conducting units. A large quantity of grain boundaries or interfaces are located between the nano-sized conducting columns, and have a poor transverse conducting performance, the longitudinal conducting layer has a poor transverse conducting capacity, the charge carriers are mainly longitudinally transmitted, and there is substantially no transverse current. Alternatively, the nano-sized conducting units are insulated by the insulating grids in the transverse direction, the longitudinal conducting layer has a poor transverse conducting capacity, the charge carriers are mainly longitudinally transmitted, and there is substantially no transverse current, which reduces the power loss of the laminated photovoltaic device.

## Description

The present application claims the priority of the Chinese patent application filed on January 21st, 2020 before the Chinese Patent Office with the application number of 202010072789.7 and the title of "INTERMEDIATE CONNECTION LAYER, LAMINATED PHOTOVOLTAIC DEVICE, AND PRODUCTION METHOD THEREOF", which is incorporated herein in its entirety by reference.

### TECHNICAL FIELD

The present disclosure relates to the technical field of solar-energy photovoltaics and, more particularly, to an intermediate series-connecting layer of a laminated photovoltaic device, a laminated photovoltaic device and a fabricating method thereof.

### BACKGROUND

Laminated photovoltaic devices can divide sunlight into multiple wave bands, and, from the front to the back, sequentially use cell units with increasingly reduced band gaps to absorb sunlights of different energies, to widen the wave bands responding to the spectra of sunlight, to reduce the energy loss. Therefore, laminated photovoltaic devices have an extensive prospect of application.

In a laminated photovoltaic device, an intermediate series-connecting layer is used to connect the cell units in series. Currently, the intermediate series-connecting layers of laminated photovoltaic devices have mainly three types, one type is a metal intermediate series-connecting layer, one type is a transparent conducting thin film intermediate series-connecting layer, and the other type is a tunnel junction intermediate series-connecting layer.

However, those intermediate series-connecting layers cause power loss of the laminated photovoltaic devices.

### SUMMARY

The present disclosure provides an intermediate series-connecting layer of a laminated photovoltaic device, a laminated photovoltaic device and a fabricating method thereof, which aims at solving the problem of the power loss of the laminated photovoltaic devices caused by the intermediate series-connecting layers.

According to the first aspect of the present disclosure, there is provided an intermediate series-connecting layer of a laminated photovoltaic device, wherein the intermediate series-connecting layer is light-transmittable;
the intermediate series-connecting layer includes a longitudinal conducting layer; and
the longitudinal conducting layer is formed by nano-sized conducting columns that longitudinally grow;
   or
the longitudinal conducting layer includes nano-sized conducting units that are spaced from each other, and insulating and separating bodies located between neighboring nano-sized conducting units, and the insulating and separating bodies transversely insulate the nano-sized conducting units.

Optionally, the nano-sized conducting columns are one of a columnar crystal, a nano-column, a nanorod and a nanotube;
a transverse dimension of the nano-sized conducting columns is 0.5-500nm; and
a material of the nano-sized conducting columns is selected from at least one of an oxide semiconductor, a selenide semiconductor, a carbide, carbon and a conducting polymer.

Optionally, an included angle between the nano-sized conducting columns and a longitudinal direction is less than or equal to 10°.

Optionally, a shape of the nano-sized conducting units is one of a linear shape, a columnar shape, a pyramidal shape and a rod-like shape;
a transverse dimension of the nano-sized conducting units is 0.5-500nm;
a material of the nano-sized conducting units is selected from at least one of a metal, a metal oxide, a metal selenide, a metal sulfide, carbon and a conducting polymer; and
a material of the insulating and separating bodies is selected from at least one of an organosilicone, an inorganic silicon compound, an oxide dielectric and a polymer.

Optionally, the metal is selected from at least one of gold, silver, platinum, aluminum, copper, tin and titanium; and
the metal oxide is selected from at least one of zinc oxide, tin oxide, titanium oxide, molybdenum oxide, cupric oxide, vanadium oxide, thallium oxide, hafnium oxide, nickel oxide, tungsten oxide, indium oxide, gallium oxide, indium-doped tin oxide, fluorine-doped tin oxide, aluminum-doped zinc oxide and gallium-doped zinc oxide.

Optionally, an included angle between the nano-sized conducting units and a longitudinal direction is less than or equal to 10°.

Optionally, an average roughness of a light facing surface of the intermediate series-connecting layer is less than or equal to 100nm.

Optionally, the intermediate series-connecting layer further includes a modifying film located on a shadow surface of the longitudinal conducting layer;
a material of the modifying film is selected from a metal, a metal oxide, a metal selenide, carbon and a carbide that have a function of catalysis, and the modifying film serves as a seed layer of the nano-sized conducting columns or the nano-sized conducting units; and/or
when the nano-sized conducting columns or the nano-sized conducting units are a low-work-function material, a material of the modifying film is selected from electron selective contact materials.

Optionally, a thickness of the modifying film is 0.5-10nm; and
the modifying film is one continuous layer, or, the modifying film is formed by a plurality of lattice structures that are densely arranged, and a transverse dimension of the lattice structures is 0.5-10nm.

Optionally, the electron selective contact materials are selected from at least one of fullerene, graphene, graphdiyne, calcium, lithium fluoride and magnesium fluoride.

Optionally, an average transmittance at a wave band of 500-1300nm of the intermediate series-connecting layer is greater than or equal to 85%.

Optionally, a longitudinal dimension of the intermediate series-connecting layer is 10-1000nm.

According to the second aspect of the present disclosure, there is provided a laminated photovoltaic device, wherein the laminated photovoltaic device includes: at least two cell units having different band gaps and the intermediate series-connecting layer according to any one of the above embodiments; and
the cell units are laminated sequentially from top to bottom in a sequence from a higher absorbing-layer band-gap-width energy to a lower absorbing-layer band-gap-width energy, and the intermediate series-connecting layer is located between neighboring cell units.

Optionally, a light trapping structure is disposed at a surface of a lower-layer cell unit that contacts the intermediate series-connecting layer, wherein the lower-layer cell unit refers to a cell unit located at a shadow surface of the intermediate series-connecting layer.

According to the third aspect of the present disclosure, there is provided a method for fabricating a laminated photovoltaic device, wherein the method includes:
providing a first cell unit;
depositing the intermediate series-connecting layer according to any one of the above embodiments on a light receiving surface of the first cell unit; and
depositing a second cell unit on a light receiving surface of the intermediate series-connecting layer, wherein a band gap width of the second cell unit is greater than a band gap width of the first cell unit; and the intermediate series-connecting layer is for conductively interconnecting the first cell unit and the second cell unit.

Optionally, the step of depositing the intermediate series-connecting layer includes:
by using one of vacuum deposition, a chemical method, chemical vapor deposition and hot-filament chemical vapor deposition, depositing to form the nano-sized conducting columns; or
by using one of vacuum deposition, a chemical method, chemical vapor deposition and hot-filament chemical vapor deposition, depositing to form the nano-sized conducting units and the insulating and separating bodies.

In the embodiments of the present disclosure, the intermediate series-connecting layer includes a longitudinal conducting layer, and the longitudinal conducting layer is formed by nano-sized conducting columns that longitudinally grow. A large quantity of grain boundaries or interfaces are located between the nano-sized conducting columns in the transverse direction, which results in that they have a poor transverse conducting performance, and a very good longitudinal conducting capacity, and, accordingly, the charge carriers are mainly longitudinally transmitted, and there is substantially no transverse current, which facilitates reducing the power loss of the laminated photovoltaic device. Alternatively, the nano-sized conducting units are insulated by the insulating and separating bodies in the transverse direction, which breaks the conducting paths in the transverse direction, so that, basically, the longitudinal conducting layer can merely perform the longitudinal transmission of the charge carriers, and there is substantially no transverse current, which facilitates reducing the power loss of the laminated photovoltaic device.

The above description is merely a summary of the technical solutions of the present disclosure. In order to more clearly know the elements of the present disclosure to enable the implementation according to the contents of the description, and in order to make the above and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure, the figures that are required to describe the embodiments of the present disclosure will be briefly introduced below. Apparently, the figures that are described below are embodiments of the present disclosure, and a person skilled in the art can obtain other figures according to these figures without paying creative work.
FIG. 1 shows a schematic structural diagram of an intermediate series-connecting layer according to an embodiment of the present disclosure;
FIG. 2 shows a schematic structural diagram of another intermediate series-connecting layer according to an embodiment of the present disclosure;
FIG. 3 shows a schematic structural diagram of an intermediate series-connecting layer and a lower-layer cell according to an embodiment of the present disclosure;
FIG. 4 shows a schematic structural diagram of the first type of the laminated photovoltaic device according to an embodiment of the present disclosure;
FIG. 5 shows a schematic structural diagram of the second type of the laminated photovoltaic device according to an embodiment of the present disclosure;
FIG. 6 shows a schematic structural diagram of the third type of the laminated photovoltaic device according to an embodiment of the present disclosure; and
FIG. 7 shows a schematic structural diagram of the fourth type of the laminated photovoltaic device according to an embodiment of the present disclosure.

### Description of the reference numbers:

1-intermediate series-connecting layer, 10-longitudinal conducting layer, 11-nano-sized conducting columns, 12-insulating and separating bodies, 13-nano-sized conducting units, 21-upper-layer cell unit, 22-lower-layer cell unit, 14-modifying film, 23-top-layer electrode, and 24-bottom-layer electrode.

### DETAILED DESCRIPTION

The technical solutions of the embodiments of the present disclosure will be clearly and completely described below with reference to the drawings of the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work fall within the protection scope of the present disclosure.

The inventor of the present disclosure has found in the studying of the above-described intermediate series-connecting layers that the reason for the power loss of the laminated photovoltaic devices caused by the intermediate series-connecting layers is that, in the fabricating process of the laminated photovoltaic devices, nonuniformity of the material characteristics in a transverse spatial region between the upper and lower layers of the cell units frequently happens. The open-circuit voltages or the photo-generated currents in different regions have a certain difference at a same time. The conventional intermediate series-connecting layers have a transverse current, which eventually causes the power loss of the laminated photovoltaic devices. Especially, when the upper-layer cell unit is a thin-film cell, if the thin film has a poor quality, or even in the case of ineffectiveness or electric leakage, the conventional intermediate series-connecting layers cause that the transmission of the charge carriers of the lower-layer cell unit is concentrated at the position of the electric leakage or ineffectiveness in the transverse direction. This is equal to reducing of the overall parallel resistance of the devices, and results in a serious reduction of the overall efficiency of the devices.

In the embodiments of the present disclosure, the intermediate series-connecting layer may be used to connect the cell units in series to form the laminated photovoltaic device. The cell units have different band gaps, and the cell units are laminated from top to bottom, and in the sequence from a higher band-gap-width energy to a lower band-gap-width energy. The cell unit having the maximum band gap is located at the front, and the cell unit of the minimum band gap is located at the back.

The intermediate series-connecting layer is light-transmittable, and is used to absorb the wave bands remaining after the light transmitting through the upper-layer cell unit. The light-transmission wave bands of the intermediate series-connecting layer may be determined according to the remaining wave bands after the light is absorbed by its neighboring upper-layer cell unit. For example, the light-transmission wave bands of the intermediate series-connecting layer may be the remaining wave bands after the light is absorbed by the neighboring upper-layer cell unit of the intermediate series-connecting layer.

In an embodiment of the present disclosure, optionally, the average transmittance at the wave band of 500-1300nm of the intermediate series-connecting layer is greater than or equal to 85%. In other words, the intermediate series-connecting layer has an average transmittance greater than or equal to 85% to the wave band of 500-1300nm, and, accordingly, greater than or equal to 85% of the light at the wave band of 500-1300nm can be transmitted to the cell unit located at the shadow surface of the intermediate series-connecting layer, which facilitates reducing the optical loss.

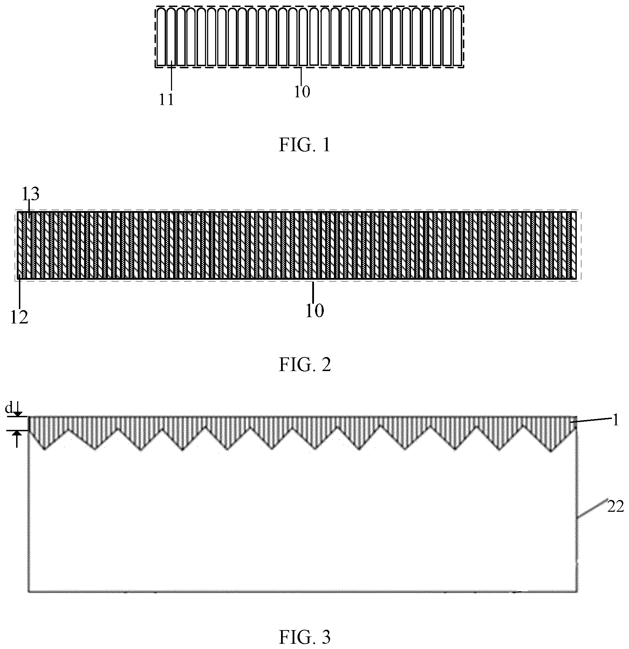

Referring to FIG. 1, it shows a schematic structural diagram of an intermediate series-connecting layer according to an embodiment of the present disclosure. Referring to FIG. 1, the intermediate series-connecting layer includes a longitudinal conducting layer 10, and the longitudinal conducting layer 10 is formed by nano-sized conducting columns 11 that longitudinally grow. It can be understood that the longitudinal direction refers to the direction perpendicular to the layers; in other words, in the laminated photovoltaic device, the longitudinal direction refers to the direction in which the cell units are laminated from top to bottom in the sequence from a higher band-gap-width energy to a lower band-gap-width energy.

The nano-sized conducting columns included in the longitudinal conducting layer are of a nano-scale, and are evenly distributed in the entire longitudinal conducting layer.

Referring to FIG. 1, the nano-sized conducting columns are closely arranged, and a large quantity of grain boundaries or interfaces are located between the nano-sized conducting columns, or there is little transverse cross-linking between the nano-sized conducting columns, which results in that they have a poor transverse conducting performance, and accordingly the longitudinal conducting layer has a poor transverse conducting capacity. At the same time, there are many longitudinal links or conducting paths between the nano-sized conducting columns, the intermediate series-connecting layer has an excellent longitudinal conducting capacity, and, accordingly, the charge carriers are mainly longitudinally transmitted, and there is substantially no transverse current, which facilitates reducing the power loss of the laminated photovoltaic device.

Optionally, the nano-sized conducting columns are one of a columnar crystal, a nano-column, a nanorod and a nanotube. The transverse dimension of the nano-sized conducting columns is 0.5-500nm. The transverse dimension may be the width, the diameter and so on of the nano-sized conducting columns. As compared with the mode of the intermediate series-connecting layers with tapping in a passivation layer and metal filling, the transverse dimension of the nano-sized conducting columns is lower, and at the same time the nano-sized conducting columns have a high distribution density. Therefore, the area for a single nano-sized conducting column to collect the charge carriers is very small, which can reduce the accumulation of the charge carriers to a large extent, and improve the longitudinal conducting capacity of the intermediate series-connecting layer.

Optionally, the material of the nano-sized conducting columns is selected from at least one of an oxide semiconductor, a selenide semiconductor, a carbide, carbon and a conducting polymer. By using those materials, the intermediate series-connecting layer has a good longitudinal electric conductivity. Moreover, except for the carbide, the carbon and the conducting polymer, the intermediate series-connecting layer formed by using an oxide semiconductor or a selenide semiconductor usually has a band gap greater than the band gap of the cell unit at its shadow surface, and has nearly no optical absorption to the light of the cell unit at its shadow surface.

For example, the material of the nano-sized conducting columns may be a metal oxide such as cupric oxide and molybdenum oxide, and an electric doping material relevant thereto. The electric doping material may include the doping of Group III metal elements such as aluminum (Al) and Gallium (Ga). The electric doping material may also include halide such as fluorine (F) and bromine (Br). The material of the nano-sized conducting columns may also be a metal selenide such as copper selenide and molybdenum selenide. The material of the nano-sized conducting columns may also be an intrinsic-conduction-type conducting polymer such as polyacetylene, polythiophene, polypyrrole, polyaniline, polyphenylene, polyphenylene vinylene and polydiacetylene, and doping materials thereof.

Optionally, the included angle between the nano-sized conducting columns and the longitudinal direction is less than or equal to 10°. In other words, the included angle between the nano-sized conducting columns and the stacking direction of the layers of the cell units is less than or equal to 10°, which ensures an excellent perpendicular light-ray transmittance. When light rays obliquely enter, there are refraction, scattering and so on between the nano-sized conducting columns in the intermediate series-connecting layer, which increases the optical path, and reduces the reflection at the surface of the lower-layer cell unit according to the above-described geometrical optics principle, to bring a certain function of reducing the reflection.

Alternatively, referring to FIG. 2, FIG. 2 shows a schematic structural diagram of another intermediate series-connecting layer according to an embodiment of the present disclosure. Referring to FIG. 2, the intermediate series-connecting layer includes a longitudinal conducting layer 10, the longitudinal conducting layer 10 includes nano-sized conducting units 13 that are spaced from each other, and insulating and separating bodies 12 located between neighboring nano-sized conducting units 13. The insulating and separating bodies 12 insulate the nano-sized conducting units 13 in a transverse direction. Because the nano-sized conducting units 13 are insulated by the insulating and separating bodies 12 in the transverse direction, the transverse conducting capacity of the nano-sized conducting units 13 in the longitudinal conducting layer is broken by the insulating and separating bodies 12, and, accordingly, the charge carriers are mainly longitudinally transmitted, and there is substantially no transverse current, which facilitates reducing the power loss of the laminated photovoltaic device.

Optionally, the shape of the nano-sized conducting units is one of a linear shape, a columnar shape, a pyramidal shape and a rod-like shape. The transverse dimension of the nano-sized conducting units is 0.5-500nm. The transverse dimension may be the width, the diameter and so on of the nano-sized conducting units. The transverse dimension of the nano-sized conducting units is low, and at the same time the nano-sized conducting units have a high distribution density, which facilitates the collection of the charge carriers.

Optionally, the material of the nano-sized conducting units is selected from at least one of a metal, a metal oxide, a metal selenide, a metal sulfide, carbon and a conducting polymer. By using those materials, the intermediate series-connecting layer has a good longitudinal electric conductivity and a good light transmittance. Moreover, except for the metal, the metal oxide, the metal selenide, the metal sulfide and the carbon material, the intermediate series-connecting layer formed by using a semiconductor material usually has a band gap greater than the band gap of the cell unit at its shadow surface, and has nearly no optical absorption to the light of the cell unit at its shadow surface. The material of the insulating and separating bodies is selected from at least one of an organosilicone, an inorganic silicon compound, an oxide dielectric and a polymer. The insulating and separating bodies formed by using those materials have an excellent effect of insulation, which further reduces the transverse conducting capacity of the intermediate series-connecting layer. Moreover, the insulating and separating bodies formed by using those materials have an excellent adhesiveness to the light facing surface of the lower-layer cell unit.

Optionally, in the materials of the nano-sized conducting units, the metal may be selected from materials of a low electrical resistivity such as gold, silver, platinum, aluminum, copper, tin and titanium. The metal oxide may be selected from oxide conducting materials such as zinc oxide, tin oxide, titanium oxide, molybdenum oxide, cupric oxide, vanadium oxide, thallium oxide, hafnium oxide, nickel oxide, tungsten oxide, indium oxide, gallium oxide, indium-doped tin oxide, fluorine-doped tin oxide, aluminum-doped zinc oxide and gallium-doped zinc oxide. By using those materials, the intermediate series-connecting layer has an excellent longitudinal conducting capacity.

For example, the nano-sized conducting units may be graphene flakes that are longitudinally grown or arranged. For example, the material of the insulating and separating bodies may be selected from intrinsic amorphous silicon, silicon nitride, silicon carbide, a silicon-oxide colloid, silica gel, aluminium oxide, epoxy resin and ethylene-vinyl acetate copolymer and so on.

Optionally, the included angle between the nano-sized conducting units and the longitudinal direction is less than or equal to 10°. In other words, the included angle between the nano-sized conducting units and the direction of the stacking of the layers of the cell units is less than or equal to 10°, which ensures an excellent perpendicular light-ray transmittance. When light rays obliquely enter, there are refraction, scattering and so on between the nano-sized conducting units in the intermediate series-connecting layer, which increases the optical path, and reduces the reflection at the surface of the lower-layer cell unit according to the above-described geometrical optics principle, to have a certain function of reducing the reflection.

Optionally, the average roughness of a light facing surface of the intermediate series-connecting layer is less than or equal to 100nm, whereby the light facing surface of the intermediate series-connecting layer has a good flatness, to create a flat-plane contacting surface for the deposition of the cell unit located at the light facing surface of the intermediate series-connecting layer. Particularly, planarization treatment may be performed to the light facing surface of the intermediate series-connecting layer by means of ion etching, chemical etching and so on. For example, excessive insulating and separating bodies are etched off, which, in an aspect, provides a flatter light facing surface, and, in another aspect, exposes the nano-sized conducting units, so as to facilitate the subsequent electrical contacting between the nano-sized conducting units and the cell unit at the light facing surface.

In a preferable embodiment, the intermediate series-connecting layer further includes a modifying film located on a shadow surface of the longitudinal conducting layer. The material of the modifying film is selected from a metal, a metal oxide, a metal selenide, carbon and a carbide that have the function of catalysis, and the modifying film serves as a seed layer of the nano-sized conducting columns or the nano-sized conducting units. And/or, when the nano-sized conducting columns or the nano-sized conducting units are a low-work-function material, the material of the modifying film is selected from electron selective contact materials.

Particularly, the modifying film may serve to modify the light facing surface of the lower-layer cell unit that contacts the intermediate series-connecting layer, which can reduce the contact resistance between the longitudinal conducting layer and the lower-layer cell unit, or serve as the growing points of the nano-sized conducting columns or the nano-sized conducting units of the longitudinal conducting layer, and serve as the light facing surface of the lower-layer cell unit that contacts the intermediate series-connecting layer. The modifying film has an excellent adhesiveness to the light facing surface of the lower-layer cell unit that contacts the intermediate series-connecting layer. The material of the modifying film may be selected according to the material of the nano-sized conducting columns or the nano-sized conducting units.

When the nano-sized conducting columns or the nano-sized conducting units in the longitudinal conducting layer are obtained at the light facing surface of the lower-layer cell unit by the mode of growing, the material of the modifying film is selected from a metal, a metal oxide, a metal selenide, carbon and a carbide that have a function of catalysis. The modifying film may serve as the seed layer of the nano-sized conducting columns or the nano-sized conducting units.

For example, when a hydrothermal method is used to grow nano-sized conducting units of silver nanowires, a layer of silver nanoparticles may be deposited on the light facing surface of the lower-layer cell unit by vapor deposition in advance as the modifying film. When a chemical vapor deposition method is used to grow the nano-sized conducting units of zinc-oxide nanowires, catalytic metal particles such as gold or zinc-oxide nanoparticles may be deposited on the light facing surface of the lower-layer cell unit in advance as the modifying film. As another example, when a chemical vapor deposition method is used to grow carbon nanotubes, catalytic metal particles such as platinum may be deposited on the light facing surface of the lower-layer cell unit in advance as the modifying film.

Furthermore, according to the demands on the passivation of the light facing surface of the lower-layer cell unit, a material having a property of passivation may also be selected to form the modifying film. For example, if a titanium-oxide thin layer is used as the modifying film on the light facing surface of the lower-layer cell unit, the titanium-oxide thin layer can serve for the surface field passivation, and at the same time the titanium-oxide thin layer can serve to reduce the contact resistance.

When the nano-sized conducting columns or the nano-sized conducting units are a low-work-function material, the material of the modifying film is selected from electron selective contact materials. The work function refers to the minimum energy that is required by moving one electron from the interior of an object to exactly the surface of the object. The low-work-function material may refer to a material that has the above-described minimum energy less than or equal to 3.0eV. For example, modified silver nanowire, zinc-oxide nanowire and carbon nanotube may be the low-work-function material. When the nano-sized conducting columns or the nano-sized conducting units are a low-work-function material, the low work function results in a good conducting capacity, but the lower work function results in a poor affinity to electrons, a poor capacity of electron collection, and a high contact resistance, whereby a high contact resistance may emerge between the longitudinal conducting layer and the light facing surface of the lower-layer cell unit. However, electron selectively-contacting materials are usually a high-work-function material, and the modifying film of a high work function can reduce the contact resistance with the light facing surface of the lower-layer cell unit. The high-work-function material may refer to a material that has the above-described minimum energy greater than 3.0eV.

Optionally, the thickness of the modifying film is 0.5-10nm. The modifying film is one continuous layer, or, the modifying film is formed by a plurality of lattice structures that are densely arranged, and the transverse dimension of the lattice structures is 0.5-10nm. Each of the lattice structures may be of a spherical shape or a hemispherical shape, and the transverse dimension may be the diameter.

Optionally, in the materials of the modifying film, the electron selective contact materials are selected from at least one of fullerene, graphene, graphdiyne, calcium, lithium fluoride and magnesium fluoride. The modifying film formed by those materials can further reduce the contact resistance with the light facing surface of the lower-layer cell unit.

Optionally, the longitudinal dimension of the intermediate series-connecting layer is 10-1000nm. The intermediate series-connecting layer has a low longitudinal dimension, so as to have a preferable light transmittance. Particularly, if the light facing surface of the lower-layer cell unit is a plane, then the longitudinal dimension of the intermediate series-connecting layer is 10-1000nm. If the light facing surface of the lower-layer cell unit is of a light trapping structure, then based on that the intermediate series-connecting layer fills the light trapping structure of the light facing surface of the lower-layer cell unit, the remaining longitudinal dimension of the intermediate series-connecting layer is 10-1000nm.

For example, referring to FIG. 3, FIG. 3 shows a schematic structural diagram of an intermediate series-connecting layer and a lower-layer cell according to an embodiment of the present disclosure. In FIG. 3, the light facing surface of the lower-layer cell unit 22 is of a light trapping structure, and excluding the thickness of the intermediate series-connecting layer 1 that fills the light trapping structure of the light facing surface of the lower-layer cell unit 22, the longitudinal dimension d of the intermediate series-connecting layer 1 is 10-1000nm above the vertexes of the light trapping structure of the light facing surface of the lower-layer cell unit 22.

Optionally, the longitudinal dimension of the nano-sized conducting columns in the longitudinal conducting layer is equal to the thickness of the longitudinal conducting layer. In other words, the nano-sized conducting columns extends throughout the entire longitudinal conducting layer along the longitudinal direction of the entire longitudinal conducting layer. In other words, the two ends of the nano-sized conducting columns are located at the two surfaces of the longitudinal conducting layer.

Alternatively, the original longitudinal dimension or the longitudinal dimension after internal crosslinking of the nano-sized conducting units in the longitudinal conducting layer is equal to the thickness of the longitudinal conducting layer. In other words, the nanowires and so on in the nano-sized conducting units directly longitudinally extend throughout the entire longitudinal conducting layer, or the nanowires and so on in the nano-sized conducting units can longitudinally extend throughout the longitudinal conducting layer after cross-linking. In other words, the two longitudinal ends of the nanowires and so on in the nano-sized conducting units are located at the two surfaces of the longitudinal conducting layer, or the two ends of the nanowires and so on in the nano-sized conducting units after cross-linking are located at the two surfaces of the longitudinal conducting layer.

In an embodiment of the present disclosure, when the light facing surface of the lower-layer cell unit is of a light trapping structure, the thickness of the intermediate series-connecting layer is greater than the size of the light trapping structure of the light facing surface of the lower-layer cell unit, to fill the light trapping structure.

A metal, a transparent conducting thin film or a tunnel junction is employed to form the intermediate series-connecting layer employs. The metal series connection causes a serious optical blocking to the lower-layer cell unit. If a thick transparent conducting thin film is used to realize the series connection, certain optical loss is introduced, and the transparent conducting thin film still has a high electrical resistivity, and has a certain transverse conducting capacity, which introduces an additional series resistance into the device. If the material characteristics in the transverse spatial region between the upper and lower layers of the cell units are nonuniform, the open-circuit voltages or the photo-generated currents in different regions might have a certain difference, and if the intermediate series-connecting layer has a high transverse conducting capacity, then a transverse current exists, which results in a power loss. Furthermore, when the upper-layer cell unit is fabricated with a poor quality and then results in ineffectiveness or electric leakage, if the intermediate series-connecting layer has a high transverse conducting capacity, the transverse transmission of the charge carriers of the lower-layer cell unit is concentrated at the position of the electric leakage or ineffectiveness, which results in a huge reduction of the overall efficiency of the device, and a large overall electric loss, the exhibition of which is a high series resistance and a low parallel resistance. Performing the electric series connection by means of tapping in a passivation layer and metal filling may reduce the optical-blocking loss caused by the metal series connection and reduces the series resistance to a certain extent, but certain optical blocking still exists. Furthermore, in order to reduce the blocking, a lower tapping quantity and a lower hole diameter are required, which results in accumulation of the charge carriers of the bottom-layer cell at the openings, to cause increasing of the overall series resistance of the device. In order to alleviate the accumulation of the charge carriers, more openings or higher hole diameters are required, which further increases the optical blocking.

However, in the embodiments of the present disclosure, the intermediate series-connecting layer includes a longitudinal conducting layer, and the longitudinal conducting layer is formed by nano-sized conducting columns that grow longitudinally. A large quantity of grain boundaries or interfaces are located between the nano-sized conducting columns, which results in that they have a poor transverse conducting performance, and accordingly the longitudinal conducting layer has a poor transverse conducting capacity. Accordingly, the charge carriers are mainly longitudinally transmitted, and there is substantially no transverse current, which alleviates electric internal friction caused by nonuniform regional material characteristics of the upper-layer and lower-layer cell units to the utmost extent, and facilitates reducing the power loss of the laminated photovoltaic device. Alternatively, the nano-sized conducting units are insulated by the insulating and separating bodies in the transverse direction, the longitudinal conducting layer has a poor transverse conducting capacity, and, accordingly, the charge carriers are mainly transmitted longitudinally, and there is substantially no transverse current, which alleviates electric internal friction caused by nonuniform regional material characteristics of the upper-layer and lower-layer cell units to the utmost extent, and facilitates reducing the power loss of the laminated photovoltaic device. Moreover, the intermediate series-connecting layer has an excellent light transmittance, a high electric conductivity and a high recombination rate, and realizes a high longitudinal electric conductivity, which reduces the blocking to the incident light to the largest extent while ensuring reducing or eliminating the accumulation of the charge carriers at the intermediate series-connecting layer.

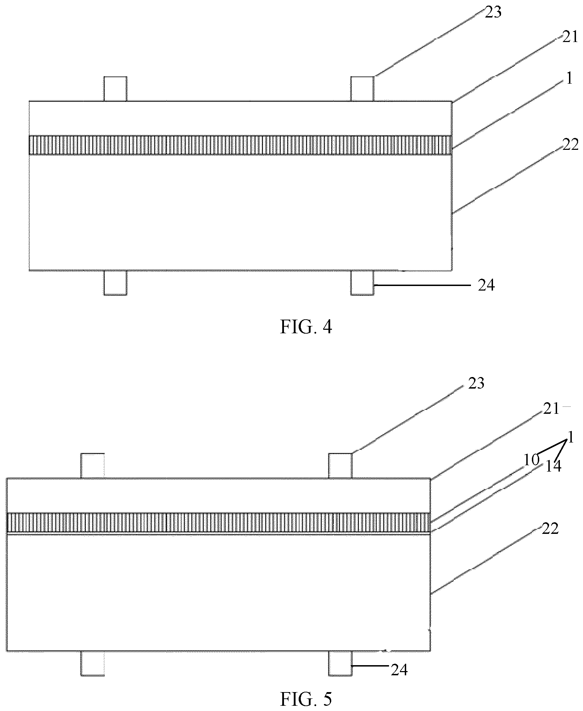

Referring to FIG. 4, FIG. 4 shows a schematic structural diagram of the first type of the laminated photovoltaic device according to an embodiment of the present disclosure.

The laminated photovoltaic device includes at least two cell units having different band gaps and any one of the above-described intermediate series-connecting layers. The quantity of the cell units included in the laminated photovoltaic device is not particularly limited. For example, referring to FIG. 4, in FIG. 4, the laminated photovoltaic device includes 2 cell units.

In the laminated photovoltaic device, the cell units are laminated from top to bottom in a sequence from a higher absorbing-layer band-gap-width energy to a lower absorbing-layer band-gap-width energy, and the intermediate series-connecting layer is located between neighboring cell units. The intermediate series-connecting layer is used to conductively interconnect the cell units.

For example, referring to FIG. 4, in two cell units, the upper cell unit 21 may be a wide-band-gap cell unit, and the lower cell unit 22 may be a narrow-band-gap cell unit. The band gap of the narrow-band-gap cell unit 22 is less than the band gap of the wide-band-gap cell unit 21. The wide-band-gap cell unit 21 and the narrow-band-gap cell unit 22 are laminated from top to bottom in the sequence from a higher absorbing-layer band-gap-width energy to a lower absorbing-layer band-gap-width energy, the intermediate series-connecting layer 1 is disposed between the wide-band-gap cell unit 21 and the narrow-band-gap cell unit 22, and the intermediate series-connecting layer 1 is used to conductively interconnect the wide-band-gap cell unit 21 and the narrow-band-gap cell unit 22.

In an embodiment of the present disclosure, the light facing surface of the lower-layer cell unit may be a plane or of a light trapping structure, and the shadow surface of the intermediate series-connecting layer and the light facing surface of the lower-layer cell unit match. For example, referring to FIG. 4, the light facing surface of the lower-layer cell unit 22 is a plane, the shadow surface of the intermediate series-connecting layer 1 is also a plane, and the light facing surface of the intermediate series-connecting layer 1 is a plane, to create a plane contacting surface for the deposition of the upper-layer cell unit 21.

As another example, referring to FIG. 5, FIG. 5 shows a schematic structural diagram of the second type of the laminated photovoltaic device according to an embodiment of the present disclosure. The light facing surface of the lower-layer cell unit 22 may be a plane surface, the intermediate series-connecting layer 1 includes a modifying film 14, and the shadow surface of the modifying film 14 is a plane matching with the light facing surface of the lower-layer cell unit 22. The light facing surface of the modifying film 14 is a plane, the shadow surface of the longitudinal conducting layer 10 is a plane matching with the light facing surface of the modifying film 14, and the light facing surface of the intermediate series-connecting layer 1 is a plane, to create a flat-plane contacting surface for the deposition of the upper-layer cell unit 21.

Optionally, a light trapping structure is disposed at the surface of a lower-layer cell unit that contacts the intermediate series-connecting layer, wherein the lower-layer cell unit refers to a cell unit located at the shadow surface of the intermediate series-connecting layer. In other words, the light facing surface of the lower-layer cell unit is of a light trapping structure, and the light trapping structure may be a nano-sized optical structure, a suede structure and so on. The nano-sized optical structure is a regular nano-sized light trapping structure. The suede structure includes structures such as a pyramid and an inversed pyramid. The light facing surface of the lower-layer cell unit is of a light trapping structure, which facilitates increasing the optical path. When the light facing surface of the lower-layer cell unit is of a light trapping structure, the intermediate series-connecting layer may be fabricated on the light facing surface of the lower-layer cell unit by using chemical coating methods such as spray coating and spin coating and a solution method, and the intermediate series-connecting layer fills and levels up the light trapping structure of the light facing surface of the lower-layer cell unit, which also creates a flat-plane contacting surface for the upper-layer cell unit.

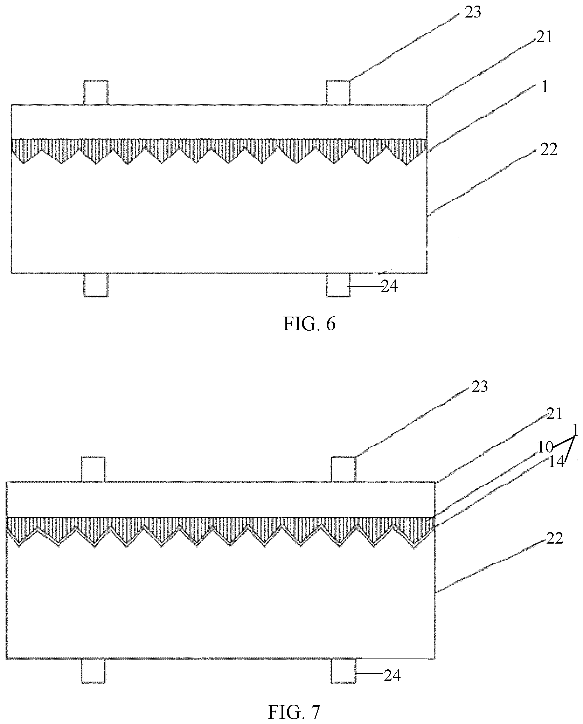

For example, referring to FIG. 6, FIG. 6 shows a schematic structural diagram of the third type of the laminated photovoltaic device according to an embodiment of the present disclosure. The light facing surface of the lower-layer cell unit 22 is of a light trapping structure, and, based on that the intermediate series-connecting layer 1 fills the light trapping structure of the light facing surface of the lower-layer cell unit 22, the light facing surface of the intermediate series-connecting layer 1 is a plane, to create a flat-plane contacting surface for the deposition of the upper-layer cell unit 21.

As another example, referring to FIG. 7, FIG. 7 shows a schematic structural diagram of the fourth type of the laminated photovoltaic device according to an embodiment of the present disclosure. In FIG. 7, the light facing surface of the lower-layer cell unit 22 is of a light trapping structure, and the intermediate series-connecting layer 1 includes a modifying film 14. Based on that the modifying film 14 of the intermediate series-connecting layer 1 and the longitudinal conducting layer 10 fill the light trapping structure of the light facing surface of the lower-layer cell unit 22, the light facing surface of the intermediate series-connecting layer 1 is a plane, to create a flat-plane contacting surface for the deposition of the upper-layer cell unit 21.

In an embodiment of the present disclosure, the thickness of the absorbing layer of the upper-layer cell unit located at the light facing surface of the intermediate series-connecting layer is regulated according to the band gap of its material, thereby enhancing the absorbing capacity of the upper-layer cell unit at the short wave band of visible light, and reduce the ineffective absorption at the long wave band of visible light. To the largest extent, the output current of the upper-layer cell unit is maintained stable to reduce the overall current loss. The upper-layer cell unit and the lower-layer cell unit that is located at the shadow surface of the intermediate series-connecting layer are required to undergo current adaptation.

The upper-layer cell unit located at the light facing surface of the intermediate series-connecting layer and the lower-layer cell unit located at the shadow surface of the intermediate series-connecting layer are required to undergo an electric polarity adaptation, to maintain the flow directions of most of the charge carriers to be the same. For example, if the upper layer of the lower-layer cell unit is of the N type, then the lower layer of the upper-layer cell unit is a hole transporting layer, and the upper layer is an electron transporting layer. On the contrary, if the upper layer of the lower-layer cell unit is of the P type, then the lower layer of the upper-layer cell unit is an electron transporting layer, and the upper layer is a hole transporting layer.

The band gap width of the lower-layer cell unit located at the shadow surface of the intermediate series-connecting layer is less than the band gap width of the upper-layer cell unit located at the light facing surface of the intermediate series-connecting layer. The lower-layer cell unit may be a crystalline-silicon solar cell, and may also be a crystalline-silicon /non-silicon heterojunction cell, and the type of the doping of its substrate silicon material is not limited, and may be thin-film solar cells such as amorphous silicon, copper indium gallium selenide, cadmium telluride and gallium arsenide. The light facing surface of the lower-layer cell unit may be of a flat-plane structure, a nano-sized optical structure or a suede structure, and the top layer has no insulating material or dielectric material. The upper-layer cell unit may be an exciton solar cell such as a perovskite material, an organic material and a quantum-dot material, and may also be a wide-band-gap semiconductor solar cell such as amorphous silicon, amorphous silicon carbide, copper indium gallium selenide, cadmium telluride and gallium arsenide. The band gap width of the absorbing material of the upper-layer cell unit may be 1.5eV-2.3eV. The upper-layer cell unit may include one or more buffer layers or matching layers required by the contacting with the intermediate series-connecting layer, to reduce the resistance or the recombination between the intermediate series-connecting layer and the upper-layer cell unit.

In the laminated photovoltaic device, an antireflection film is disposed at the light facing surface of a top-layer cell unit. The antireflection film is used to reduce the overall optical loss of the laminated photovoltaic device. The top-layer cell unit refers to the cell unit having the maximum band gap in the laminated photovoltaic device. Referring to FIG. 4, FIG. 5, FIG. 6 or FIG. 7, the laminated photovoltaic device may further include a top-layer electrode 23 and a bottom-layer electrode 24. The electrodes are used to collect and export the charge carriers.

The lower-layer cell unit may also be a homojunction silicon solar cell. By using a P-type silicon wafer, an N-type layer is prepared by thermal diffusion or ion implantation to form the PN junctions, wherein the PN junctions are located at the light facing surface of the lower-layer cell unit. In order to increase the photoelectric conversion efficiency of the lower-layer cell unit, an electric exporting structure (PERC) including a passivation layer and openings may be fabricated at the shadow surface of the lower-layer cell unit, full or local heavy doping (PERT and PERL) may be further employed at the shadow surface, and the light facing surface may be a polished surface. In order to reduce the optical loss, a nano-sized optical structure or suede structure may be fabricated at the light facing surface of the lower-layer cell unit. An oxide may be deposited at the light facing surface of the lower-layer cell unit to tunnel the passivation layer and the intermediate series-connecting layer. The light facing surface of the lower-layer cell unit is not deposited a dielectric material or an antireflection thin film, to facilitate the electric contacting with the intermediate series-connecting layer. In this case, an inversed-pyramid suede structure is fabricated at the light facing surface of the lower-layer cell unit. The inversed-pyramid suede structure may have an average side length of 500nm, an average edge distance of 5nm and a structure depth of 250-500nm. The inversed-pyramid structure may be obtained by anisotropic etching assisted by metal ions.

The lower-layer cell unit may also be a narrow-band-gap thin-film solar cell, and the material of the absorbing layer may be a narrow-band-gap or regulatable-band-gap material such as CIGS, amorphous silicon, CdTe, GaAs and perovskite. The lower-layer cell unit is a CIGS thin-film solar cell, and has a conventional structure including a substrate, a molybdenum back electrode, a CIGS absorbing layer, a CdS buffer layer, a ZnO window layer and an AZO transparent conducting thin film. The lower-layer cell unit has a flat light facing surface, which serves as the part contacting the intermediate series-connecting layer, and has a longitudinal surface roughness of approximately 20nm.

In the embodiments of the present disclosure, the cell units, the intermediate series-connecting layer and so on in the laminated photovoltaic device may be referred to the relevant description in the above embodiments, to obtain the same or similar advantageous effects, which, in order to avoid replication, is not discussed herein further.

An embodiment of the present disclosure further provides a method for fabricating a laminated photovoltaic device. The method includes the following steps:

Step 101: providing a first cell unit.

In an embodiment of the present disclosure, the first cell unit may be the lower-layer cell unit having a narrower band gap described above.

Step 102: depositing the intermediate series-connecting layer according to any one of the above embodiments on a light receiving surface of the first cell unit.

Step 103: depositing a second cell unit on a light receiving surface of the intermediate series-connecting layer, wherein a band gap width of the second cell unit is greater than a band gap width of the first cell unit; and the intermediate series-connecting layer is for conductively interconnecting the first cell unit and the second cell unit.

Optionally, step 102 may include:
by using one of vacuum deposition, a chemical method, chemical vapor deposition and hot-filament chemical vapor deposition, depositing to form the nano-sized conducting columns; or
by using one of vacuum deposition, a chemical method, chemical vapor deposition and hot-filament chemical vapor deposition, depositing to form the nano-sized conducting units and the insulating and separating bodies.

Particularly, by using one of vacuum deposition, a chemical method, chemical vapor deposition and hot-filament chemical vapor deposition, on the light facing surface of the lower-layer cell unit, a plurality of nano-sized conducting columns are formed by deposition, to form the longitudinal conducting layer. Alternatively, by using one of vacuum deposition, a chemical method, chemical vapor deposition and hot-filament chemical vapor deposition, on the light facing surface of the lower-layer cell unit, a plurality of nano-sized conducting units and insulating and separating bodies are formed by deposition.

For example, by using one of vacuum deposition, a chemical method, chemical vapor deposition and hot-filament chemical vapor deposition, on the light facing surface of the lower-layer cell unit, a plurality of nano-sized conducting units and insulating and separating bodies are formed by deposition at a same time, to form the longitudinal conducting layer. Alternatively, by using one of vacuum deposition, a chemical method, chemical vapor deposition and hot-filament chemical vapor deposition, firstly, on the light facing surface of the lower-layer cell unit, the insulating and separating bodies are formed by deposition, and, subsequently, by using one of vacuum deposition, a chemical method, chemical vapor deposition and hot-filament chemical vapor deposition, a plurality of nano-sized conducting units are formed by deposition between the insulating and separating bodies, to form the longitudinal conducting layer. In an embodiment of the present disclosure, the sequence of the depositions of the insulating and separating bodies and the nano-sized conducting units is not particularly limited.

In an embodiment of the present disclosure, the vacuum deposition may be performed by using PECVD (Plasma Enhanced Chemical Vapor Deposition), LPCVD (Low Pressure Chemical Vapor Deposition), PVD (Physical Vapor Deposition) and so on. The hot-filament chemical vapor deposition is also referred to as Hot Wire Chemical Vapor Deposition i.e., HWCVD. The chemical vapor deposition refers to Chemical Vapor Deposition, i.e., CVD.

For example, regarding insulating and separating bodies such as intrinsic amorphous silicon, silicon nitride, silicon carbide and aluminium oxide, the process may be based on a chemical method, for example, a liquid-state treating process such as sol-gel may be used, and a solution of firstly spread-coating and subsequently solidifying is adopted, to deposit materials such as organosilicone, a polymer, epoxy resin and ethylene-vinyl acetate copolymer.

Optionally, on the light facing surface of the lower-layer cell unit, the modifying film may be deposited by vapor deposition. The modifying film may be of a seed-layer lattice structure. For example, the seed material may be zinc oxide ZnO, the average diameter of the seed-layer lattice may be 10nm, and the planar spacing between the seed points is 200nm. The background vacuum degree of the vapor-depositing chamber is not greater than 5×10⁻⁴ Pa, and the vapor-deposition speed is 0.1-0.5nm/s.

ZnO nanowires may be grown on the seed layer by using CVD (Chemical Vapor Deposition), with an average length of 600nm, a wire diameter of 10-50nm, and an included angle between the nanowires and the longitudinal direction of 0°. In the CVD method, argon may be used as the carrier gas, and the gas flow and the delivery speed of the zinc source may be controlled, to cause the growth rate of the ZnO to be approximately 2-3nm/s or 1-2nm/s.

As another example, the insulating and separating bodies may be deposited by LPCVD. For example, the material of the insulating and separating bodies is intrinsic amorphous silicon, which has a thickness that fills and covers the inversed-pyramid structure of the lower-layer solar cell and the ZnO nanowires, and the deposition thickness is 600-800nm. Argon may be used as the carrier gas, the background vacuum degree of the vapor-depositing chamber is not greater than 5×10⁻⁵ Pa, the system gas pressure is 100-1000Pa, and the deposition rate is approximately 10-20nm/min or 5-10nm/min. After the deposition, planarization treatment is performed to the surface by means of ion etching or chemical etching, to etch off excessive insulating and separating bodies and expose the ZnO nanowires, to perform electric contacting with the upper-layer cell unit, and the surface roughness is controlled so that the average longitudinal roughness is not greater than 10nm.

As another example, the intermediate series-connecting layer may be deposited by a sol-gel method. The precursor solution contains magnetic silver nanowires that are uniformly dispersed, and the nanowires have an average wire diameter of 10-20nm, and an average length of 50nm. After the precursor solution has been spread-coated onto the surface of the lower-layer cell unit, the precursor solution is solidified in a magnetic field, and a SiO₂ mesoporous thin film is formed after the solidification, in which the silver nanowires obtain the same longitudinal arrangement and contact the AZO, with a deviation between the average angle and the longitudinal direction not greater than 3°. Subsequently the intermediate series-connecting layer is etched by using an alkali solution, to expose the silver nanowires at the surface, and the thickness of the intermediate series-connecting layer is approximately 40-50nm.

As another example, on the light facing surface of the lower-layer cell unit, the modifying film may be deposited by vapor deposition. The modifying film is of a seed-layer lattice structure, the seed material is a titanium oxide lattice, the average diameter of the seed-layer lattice is 5nm, and the seed points are closely arranged. Titanium-oxide nanowires are grown and closely arranged on the seed layer by using a hydrothermal method, with an average length of 50nm, a wire diameter of 5-10nm, and an angular deviation between the nanowires and the longitudinal direction not greater than 3°. An organic titanium source is used to form the precursor solution of the hydrothermal method, the hydrothermal temperature does not exceed 200°C, a neutral environments is made for the crystallization growth, and the growth rate is approximately 3-4nm/min.

In the embodiments of the present disclosure, the shapes, sizes, materials and so on of the nano-sized conducting columns, the nano-sized conducting units, the insulating and separating bodies and the longitudinal conducting layer may be referred to the above-described relevant contents, which, in order to avoid replication, is not discussed herein further. The method for fabricating the intermediate series-connecting layer of the laminated photovoltaic device can also reach the similar advantageous effects, which, in order to avoid replication, is not discussed herein further.

The second cell unit may be deposited by using an anti-vacuum mode. The second cell unit may be the upper-layer cell unit having a wider band gap described above. For example, the deposition of the second solar cell may include the following steps:

Firstly, spin-coating the material of the nano-sized conducting columns on the light facing surface of the upper-layer cell unit to form the longitudinal conducting layer, wherein the average thickness of the nano-sized conducting columns may be 50nm; subsequently, at the light facing surface of the longitudinal conducting layer, spin-coating and solidifying a perovskite material, wherein the solidification temperature does not exceed 150°C, and the thickness of the perovskite material is 500-1000nm; and depositing a hole transporting layer and a TCO thin film on the surface of the perovskite absorbing layer. Alternatively, the process may include, firstly, on the light facing surface of the intermediate series-connecting layer, depositing the material of a hole transporting layer, Spiro-OMeTAD, with an average thickness of 30nm; subsequently, spin-coating and solidifying a perovskite material, wherein the solidification temperature does not exceed 150°C, and the thickness of the perovskite material is 500-1000nm; and depositing an electron transporting layer and a TCO thin film on the surface of the perovskite absorbing layer.

In the embodiments of the present disclosure, the first cell unit, the second cell unit, the intermediate series-connecting layer and so on in the method may be referred to the relevant description in the above embodiments, to obtain the same or similar advantageous effects, which, in order to avoid replication, is not discussed herein further.

It should be noted that, regarding the process embodiments, for brevity of the description, all of them are expressed as the combination of a series of actions, but a person skilled in the art should know that the embodiments of the present disclosure are not limited by the sequences of the actions that are described, because, according to the embodiments of the present disclosure, some of the steps may have other sequences or be performed simultaneously. Secondly, a person skilled in the art should also know that all of the embodiments described in the description are preferable embodiments, and not all of the actions that they involve are required by the embodiments of the present disclosure.

In the embodiments of the present disclosure, regarding the intermediate series-connecting layer, the laminated photovoltaic device and the fabricating method thereof, all of the components may refer to each other.

The embodiments of the present disclosure are described above with reference to the drawings. However, the present disclosure is not limited to the above particular embodiments. The above particular embodiments are merely illustrative, rather than limitative. A person skilled in the art, under the motivation of the present disclosure, can make many variations without departing from the spirit of the present disclosure and the protection scope of the claims, and all of the variations fall within the protection scope of the present disclosure.

## Claims

1. An intermediate series-connecting layer of a laminated photovoltaic device, wherein the intermediate series-connecting layer is light-transmittable;
the intermediate series-connecting layer comprises a longitudinal conducting layer; and
the longitudinal conducting layer is formed by nano-sized conducting columns that longitudinally grow;
or
the longitudinal conducting layer comprises nano-sized conducting units that are spaced from each other, and insulating and separating bodies located between neighboring nano-sized conducting units, and the insulating and separating bodies transversely insulate the nano-sized conducting units.

2. The intermediate series-connecting layer according to claim 1, wherein the nano-sized conducting columns are one of a columnar crystal, a nano-column, a nanorod and a nanotube;
a transverse dimension of the nano-sized conducting columns is 0.5nm-500nm; and
a material of the nano-sized conducting columns is selected from at least one of an oxide semiconductor, a selenide semiconductor, a carbide, carbon and a conducting polymer.

3. The intermediate series-connecting layer according to claim 1, wherein an included angle between the nano-sized conducting columns and a longitudinal direction is less than or equal to 10°.

4. The intermediate series-connecting layer according to claim 1, wherein a shape of the nano-sized conducting units is one of a linear shape, a columnar shape, a pyramidal shape and a rod-like shape;
a transverse dimension of the nano-sized conducting units is 0.5nm-500nm;
a material of the nano-sized conducting units is selected from at least one of a metal, a metal oxide, a metal selenide, a metal sulfide, carbon and a conducting polymer; and
a material of the insulating and separating bodies is selected from at least one of an organosilicone, an inorganic silicon compound, an oxide dielectric and a polymer.

5. The intermediate series-connecting layer according to claim 4, wherein the metal is selected from at least one of gold, silver, platinum, aluminum, copper, tin and titanium; and
the metal oxide is selected from at least one of zinc oxide, tin oxide, titanium oxide, molybdenum oxide, cupric oxide, vanadium oxide, thallium oxide, hafnium oxide, nickel oxide, tungsten oxide, indium oxide, gallium oxide, indium-doped tin oxide, fluorine-doped tin oxide, aluminum-doped zinc oxide and gallium-doped zinc oxide.

6. The intermediate series-connecting layer according to claim 1, wherein an included angle between the nano-sized conducting units and a longitudinal direction is less than or equal to 10°.

7. The intermediate series-connecting layer according to claim 1, wherein an average roughness of a light facing surface of the intermediate series-connecting layer is less than or equal to 100nm.

8. The intermediate series-connecting layer according to claim 1, wherein the intermediate series-connecting layer further comprises a modifying film located on a shadow surface of the longitudinal conducting layer;
a material of the modifying film is selected from a metal, a metal oxide, a metal selenide, carbon and a carbide that have a function of catalysis, and the modifying film serves as a seed layer of the nano-sized conducting columns or the nano-sized conducting units; and/or
when the nano-sized conducting columns or the nano-sized conducting units are a low-work-function material, a material of the modifying film is selected from electron selective contact materials.

9. The intermediate series-connecting layer according to claim 8, wherein a thickness of the modifying film is 0.5nm-10nm; and
the modifying film is one continuous layer, or, the modifying film is formed by a plurality of lattice structures that are densely arranged, and a transverse dimension of the lattice structures is 0.5nm-10nm.

10. The intermediate series-connecting layer according to claim 8, wherein the electron selective contact materials are selected from at least one of fullerene, graphene, graphdiyne, calcium, lithium fluoride and magnesium fluoride.

11. The intermediate series-connecting layer according to claim 1, wherein for the intermediate series-connecting layer, an average transmittance at a wave band of 500nm-1300nm is greater than or equal to 85%.

12. The intermediate series-connecting layer according to claim 1, wherein a longitudinal dimension of the intermediate series-connecting layer is 10nm-1000nm.

13. A laminated photovoltaic device, comprising at least two cell units and an intermediate series-connecting layer, wherein the at least two cell units has different band gaps, and the intermediate series-connecting layer is the intermediate series-connecting layer according to any one of claims 1 to 12; and
the cell units are laminated from top to bottom in a sequence from a higher absorbing-layer band-gap-width energy to a lower absorbing-layer band-gap-width energy, and the intermediate series-connecting layer is located between neighboring cell units.

14. The laminated photovoltaic device according to claim 13, wherein
a light trapping structure is disposed at a surface of a lower-layer cell unit that contacts the intermediate series-connecting layer, wherein the lower-layer cell unit refers to a cell unit located at a shadow surface of the intermediate series-connecting layer.

15. A method for fabricating a laminated photovoltaic device, wherein the method comprises:
providing a first cell unit;
depositing the intermediate series-connecting layer according to any one of claims 1 to 12 on a light receiving surface of the first cell unit; and
depositing a second cell unit on a light receiving surface of the intermediate series-connecting layer, wherein a band gap width of the second cell unit is greater than a band gap width of the first cell unit; and the intermediate series-connecting layer is for conductively interconnecting the first cell unit and the second cell unit.

16. The method according to claim 15, wherein the step of depositing the intermediate series-connecting layer comprises:
by using one of vacuum deposition, a chemical method, chemical vapor deposition and hot-filament chemical vapor deposition, depositing to form the nano-sized conducting columns; or
by using one of vacuum deposition, a chemical method, chemical vapor deposition and hot-filament chemical vapor deposition, depositing to form the nano-sized conducting units and the insulating and separating bodies.
